(19) Europäisches Patentamt
European Patent Office
Office européen des brevets

(11) EP 2 746 287 B1

(12) **EUROPEAN PATENT SPECIFICATION**

(45) Date of publication and mention of the grant of the patent:
**24.05.2017 Bulletin 2017/21**

(21) Application number: **13190489.8**

(22) Date of filing: **28.10.2013**

(51) Int Cl.:
*C08G 59/08* (2006.01) *C08G 59/62* (2006.01)
*C08G 59/68* (2006.01) *C08K 5/50* (2006.01)
*C08K 5/5419* (2006.01) *H01L 23/29* (2006.01)
*C07F 9/54* (2006.01) *C08L 63/00* (2006.01)

(54) **Quaternary phosphonium salt, epoxy resin composition for encapsulating semiconductor device including the quaternary phosphonium salt and semiconductor device encapsulated with the epoxy resin composition**

Quaternäres Phosphoniumsalz, Epoxidharzzusammensetzung zur Verkapselung einer Halbleitervorrichtung einschließlich des quaternären Phosphoniumsalzes und mit der Epoxidharzzusammensetzung verkapselte Halbleitervorrichtung

Sel de phosphonium quaternaire, composition de résine époxy pour encapsulation d'un dispositif semi-conducteur comprenant le sel de phosphonium quaternaire et dispositif à semi-conducteur encapsulé avec cette composition de résine époxy

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.12.2012 KR 20120152620**

(43) Date of publication of application:
**25.06.2014 Bulletin 2014/26**

(73) Proprietor: **CHEIL INDUSTRIES INC.**
**Gumi-si,**
**Gyeongsangbuk-do 730-710 (KR)**

(72) Inventors:
- **Kim, Min Gyum**
  **Uiwang-si (KR)**
- **Han, Seung**
  **Uiwang-si (KR)**
- **Cheon, Hwan Sung**
  **Uiwang-si (KR)**

(74) Representative: **Michalski Hüttermann & Partner Patentanwälte mbB**
**Speditionstraße 21**
**40221 Düsseldorf (DE)**

(56) References cited:
**WO-A1-03/082976** **WO-A1-2010/078300**
**JP-A- 2006 307 131** **US-A1- 2009 234 080**

- **DATABASE CA [Online] CHEMICAL ABSTRACTS SERVICE, COLUMBUS, OHIO, US; 1994, SUGIURA, MASAHITO ET AL: "Thermoplastic synthetic polymer modifiers containing sulfoisophthalate groups and their use", XP002722633, retrieved from STN Database accession no. 1994:55865 & JP 5 163335 A (TAKEMOTO OIL & FAT CO LTD, JAPAN) 29 June 1993 (1993-06-29)**
- **DATABASE CA [Online] CHEMICAL ABSTRACTS SERVICE, COLUMBUS, OHIO, US; 1993, FUJITA, HIROSHI ET AL: "Washfast antistatic cationic-dyeable polyester fibers", XP002722634, retrieved from STN Database accession no. 1993:23681 & JP 4 153319 A (TEIJIN LTD., JAPAN; DAIICHI KOGYO SEIYAKU CO., LTD.) 26 May 1992 (1992-05-26)**
- **ALOK R. PAITAL ET AL: "Synthesis and structures of perthio- and polymeric metal complexes with the tetrathio- and dithioterephthalate ligands", POLYHEDRON, vol. 64, 22 June 2013 (2013-06-22), pages 328-338, XP055111256, ISSN: 0277-5387, DOI: 10.1016/j.poly.2013.06.003**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 746 287 B1

## Description

### Field of the Invention

The present invention relates to a quaternary phosphonium salt, an epoxy resin composition for encapsulating a semiconductor device including the quaternary phosphonium salt, and a semiconductor device encapsulated with the epoxy resin composition. More particularly, the present invention relates to an epoxy resin composition for encapsulating a semiconductor device including a novel quaternary phosphonium salt as a curing accelerator, and a semiconductor device encapsulated with the epoxy resin composition.

### Description of the Related Art

Transfer molding is widely used as a method of packaging semiconductor devices, such as ICs and LSIs, with epoxy resin compositions to obtain semiconductor modules due to its advantages of low cost and suitability for mass production. Particularly, in transfer molding, modification of epoxy resins or phenolic resins as curing agents can lead to improvements in the characteristics and reliability of semiconductor modules.

Epoxy resin compositions for packaging electrical and electronic materials use amine compounds such as tertiary amines, imidazoles and the like, phosphines, phosphonium salts, etc. for the purpose of promoting curing of the resins.

With the trend toward small, lightweight and high-performance electronic devices, high integration of semiconductor devices has been accelerated year by year. Problems unsolved by conventional epoxy resin compositions arise with increasing demand for surface mounting of semiconductor modules. Other requirements of packaging materials for semiconductor devices are fast curability aimed at achieving improved productivity and storage stability aimed at achieving improved handling performance during distribution and storage.

In an attempt to meet the above requirements and solve the above problems, the use of an addition product of triphenylphosphine and 1,4-benzoquinone as a curing accelerator is known. However, such a curing accelerator exhibits a curing accelerating effect in a relatively low temperature region. For example, when an epoxy resin composition is mixed with other components before curing, the epoxy resin composition is partially cured by heat generated from the mixture system or externally applied heat. Another problem is that after completion of mixing, the epoxy resin composition may undergo curing even during storage at room temperature.

In the case where the epoxy resin composition takes the form of a liquid, the partial curing brings about an increase in viscosity or deterioration of flowability. The epoxy resin composition in the form of a solid becomes viscous by the partial curing. Furthermore, such a state change is not uniform within the epoxy resin composition. As a result, curing of the epoxy resin composition at high temperature leads to insufficient flowability of the epoxy resin composition, which is accompanied by a deterioration in the moldability of the epoxy resin composition and poor mechanical, electrical and chemical properties of the molded product.

Accordingly, the use of the curing accelerator deteriorates the storage stability of the epoxy resin composition. This necessitates strict quality management when mixing various components and strict management of the epoxy resin composition under low-temperature storage, low-temperature transport, and molding conditions. Further, the epoxy resin composition becomes difficult to handle.

High-density packaging is required in recent packaging techniques for electronic components and devices. Under such circumstances, surface mounting type packages are becoming more common than conventional pin insertion type packages. However, surface mounting type packages tend to exhibit inferior resistance to package cracks during soldering, in comparison with pin insertion type packages. That is, in surface-mounted ICs and LSIs, the occupied volume of the devices in the package is gradually increased and the thickness of the package is significantly reduced in order to achieve high packaging density. Surface mounting type packages are exposed to high temperature of 200 °C or more during soldering reflow. For this reason, the presence of moisture or a volatile component in a surface mounting type package leads to rapid expansion of the package during soldering. This expansion tends to cause cracks in a semiconductor module. Further, insufficient adhesion at the interface between a cured product of an epoxy resin composition and a semiconductor device or a lead frame present in a semiconductor module in a high-temperature reflow process may cause peeling at the interface and deterioration of moisture resistance reliability.

However, sufficient moisture resistance reliability or crack resistance cannot be attained in a semiconductor module including a semiconductor device packaged with a cured product of an epoxy resin composition using a curing accelerator such as an addition product of triphenylphosphonium and 1,4-benzoquinone that is currently in use.

There is thus a need for a latent curing accelerator that can ensure good storage stability and sufficient flowability of an epoxy resin composition while achieving good crack resistance and high moisture resistance reliability. Phosphonium salts are *inter alia* described in the JP 1993-163335, the JP 1992-153319A, the JP 2006-307131 A, the US 2009/234080 A1, the WO2010/078300A1, in Paital et al, Polyhedron 2013, p. 328- 338 and in the WO 03/082976.

## Summary of the Invention

It is an object of the present invention to provide a quaternary phosphonium salt that ensures good room temperature storage stability, sufficient flowability upon curing, and high curability of an epoxy resin composition.

It is another object of the present invention to provide an epoxy resin composition for encapsulating a semiconductor device which includes the quaternary phosphonium salt to achieve good crack resistance and high moisture resistance reliability.

It is a further object of the present invention to provide a semiconductor device encapsulated with the epoxy resin composition.

One aspect of the present invention relates to a quaternary phosphonium salt. The quaternary phosphonium salt is represented by Formula 1:

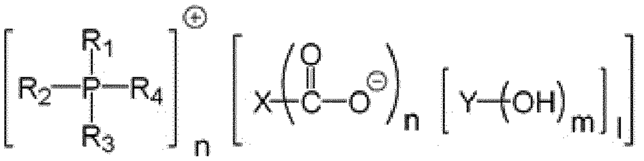

(1)

wherein R1, R2, R3 and R4 are each independently an unsubstituted benzene group; X is an unsubstituted benzene group; Y is an unsubstituted benzene group, a naphtalene group or a Si substituted with one to three unsubstituted benzene groups; n is 2; m is an integer from 1 to 6; 1 is a number greater than 0 to 6, provided that when Y is Si, the sum of m and the number of the substituents is a maximum of 4.

In one embodiment, $R_1$, $R_2$, $R_3$, and $R_4$ may be each independently an unsubstituted benzene group.

In one embodiment, X may be an unsubstituted benzene group.

In one embodiment, Y may be an unsubstituted benzene group, an unsubstituted naphthalene group, or Si substituted with one to three unsubstituted benzene groups.

In one embodiment, m may be 2 or 3.

In one embodiment, 1 may be 2, 3, or 4.

In one embodiment, the quaternary phosphonium salt may be any one of the compounds represented by Formulas 1a to 1k:

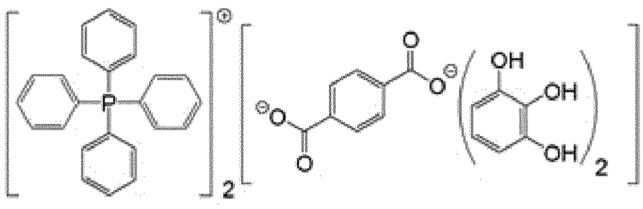

(1a)

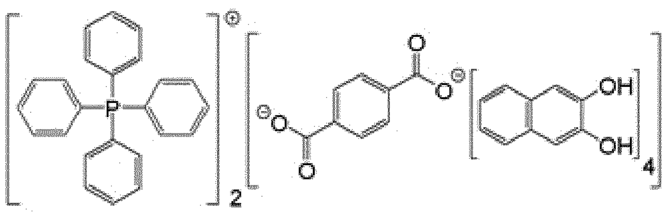

(1b)

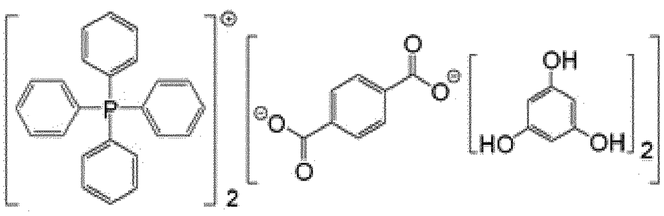

(1c)

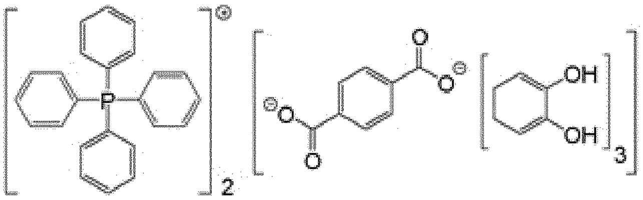

(1d)

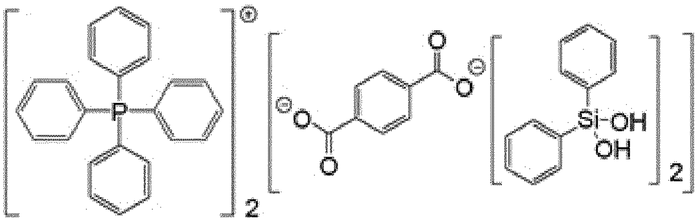

(1e)

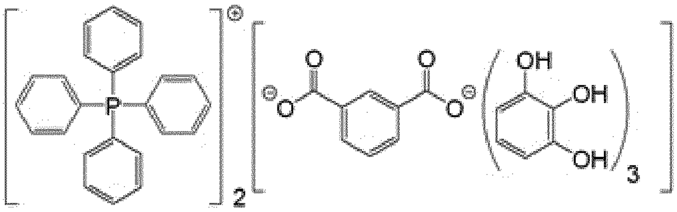

(1f)

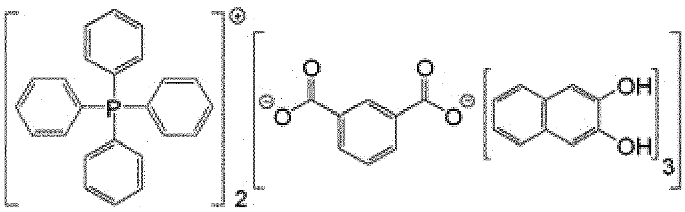

(1g)

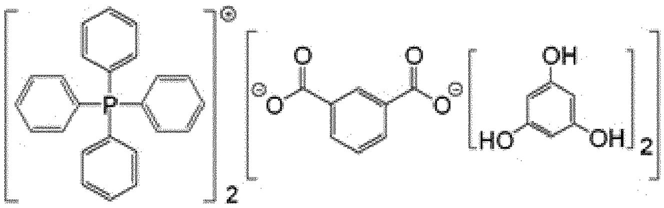

(1h)

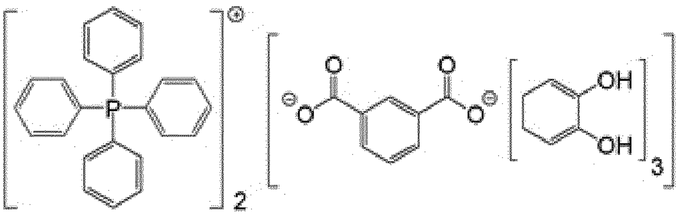

(1i)

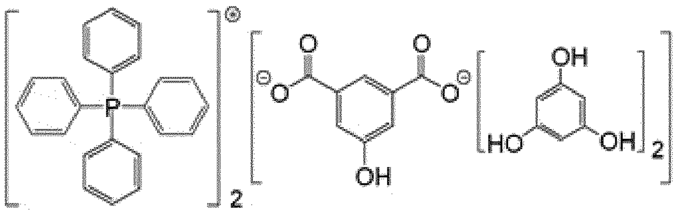

(1j)

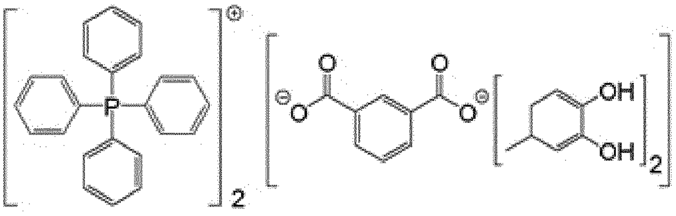

(1k)

Another aspect of the present invention relates to an epoxy resin composition. The epoxy resin composition includes an epoxy resin, a curing agent, a curing accelerator, and an inorganic filler wherein the curing accelerator includes a quaternary phosphonium salt represented by Formula 1:

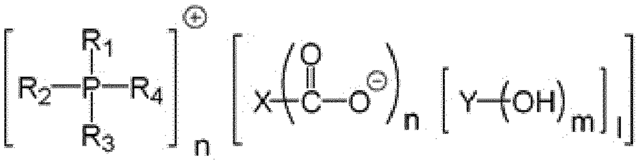

(1)

wherein R1, R2, R3 and R4 are each independently an unsubstituted benzene group; X is an unsubstituted benzene group; Y is an unsubstituted benzene group, a naphtalene group or a Si substituted with one to three unsubstituted benzene groups; n is 2; m is an integer from 1 to 6; 1 is a number greater than 0 to 6, provided that when Y is Si, the sum of m and the number of the substituents is a maximum of 4.

In one embodiment, $R_1$, $R_2$, $R_3$, and $R_4$ may be each an unsubstituted benzene group.

In one embodiment, X may be an unsubstituted benzene group.

In one embodiment, Y may be an unsubstituted benzene group, an unsubstituted naphthalene group, or Si substituted with one to three unsubstituted benzene groups. n is 2.

In one embodiment, m may be 2 or 3.

In one embodiment, 1 may be 2, 3, or 4.

In one embodiment, the quaternary phosphonium salt may be any one of the compounds represented by Formulas 1a to 1k:

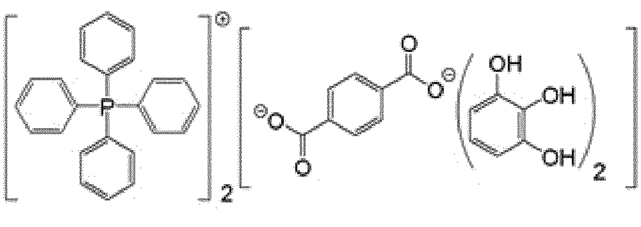

(1a)

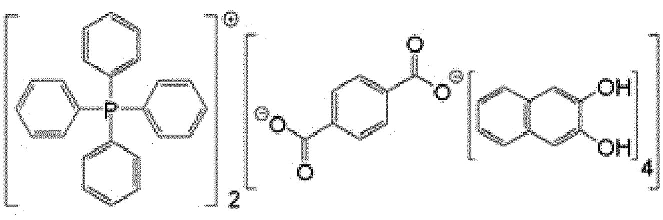

(1b)

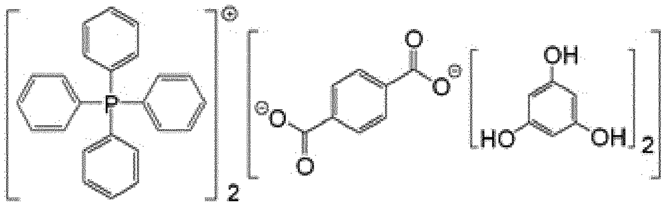
(1c)

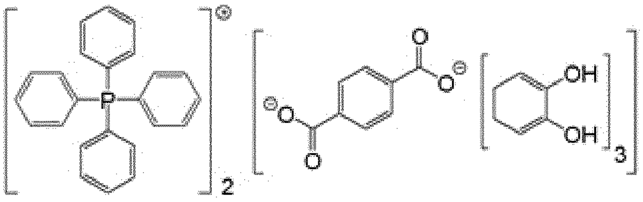
(1d)

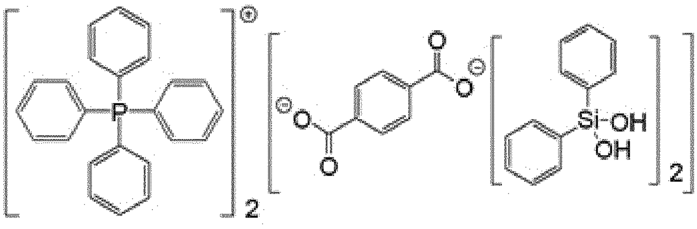
(1e)

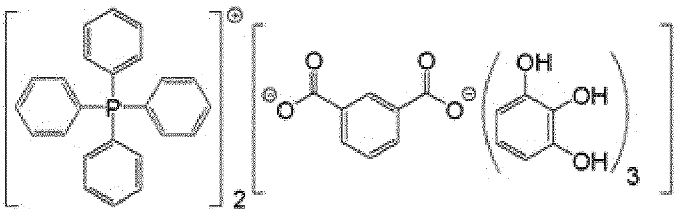
(1f)

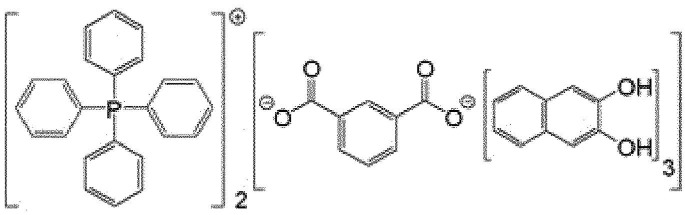
(1g)

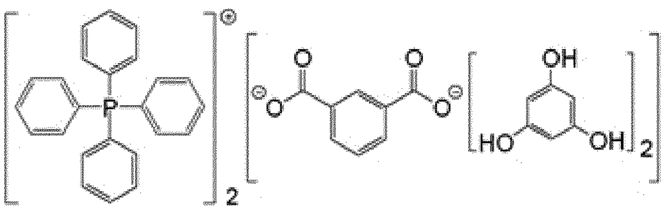
(1h)

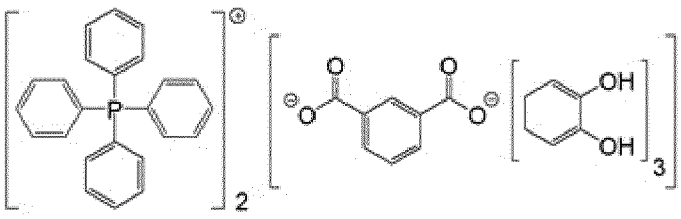

(1i)

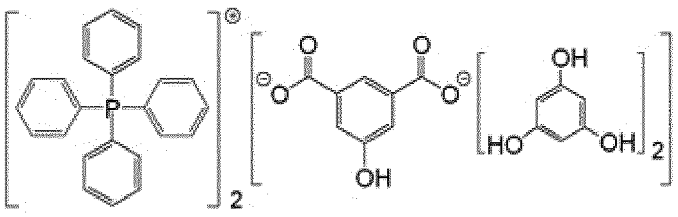

(1j)

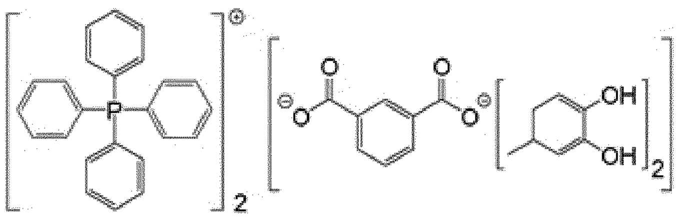

(1k)

In one embodiment, the epoxy resin may be present in amounts of ≥1% to ≤20% by weight,preferably ≥1.2% to ≤13% by weight, more preferred ≥1.5% to ≤10% by weight, based on the total weight of the epoxy resin composition.

In one embodiment, the curing agent may be present in amount of ≥1% to ≤20% by weight, preferably ≥1.5% to ≤10% by weight, more preferably ≥2% to ≤8% by weight, based on the total weight of the epoxy resin composition

In one embodiment, the curing accelerator may be present in amounts of ≥0.001% to ≤2% by weight, preferably ≥0.001% to ≤1.5% by weight, more preferably ≥0.01% to ≤1% by weight, based on the total weight of the epoxy resin composition.

In one embodiment, the inorganic filler may be present in amounts of ≥70% to ≤95% by weight, preferably ≥75% to ≤94% by weight, more preferably ≥82% to ≤92% by weight, based on the total weight of the epoxy resin composition.

In one embodiment, the epoxy resin may include at least one of epoxy resins obtained by epoxidation of condensation products of phenol or alkyl phenols and hydroxybenzaldehyde, phenol novolac type epoxy resins, cresol novolac type epoxy resins, polyfunctional epoxy resins, naphthol novolac type epoxy resins, novolac type epoxy resins of bisphenol A/bisphenol F/bisphenol AD, glycidyl ethers of bisphenol A/bisphenol F/bisphenol AD, bishydroxybiphenyl-based epoxy resins, dicyclopentadiene-based epoxy resins, biphenyl type epoxy resins, polycyclic aromatic-modified epoxy resins, bisphenol A type epoxy resins, ortho-cresol novolac type epoxy resins, phenol aralkyl type epoxy resins, and naphthalene-based epoxy resins.

In one embodiment, the curing agent may include at least one of phenol aralkyl type phenolic resins, xyloc type phenolic resins, phenol novolac type phenolic resins, cresol novolac type phenolic resins, naphthol type phenolic resins, terpene type phenolic resins, polyfunctional phenolic resins, polycyclic aromatic phenolic resins, dicyclopentadiene-based phenolic resins, terpene-modified phenolic resins, dicyclopentadiene-modified phenolic resins, novolac type phenolic resins synthesized from bisphenol A and resorcinol, polyhydric phenolic compounds, including tris(hydroxyphenyl)methane and dihydroxybiphenyl, acid anhydrides, including maleic anhydride and phthalic anhydride, metaphenylenediamine, diaminodiphenylmethane, and diaminodiphenylsulfone.

In one embodiment, the epoxy resin and the curing agent may be present in such amounts that the ratio of the epoxy equivalent weight of the epoxy resin to the phenolic hydroxyl or amine equivalent weight of the curing agent is from ≥0.5:1 to ≤2:1. preferably ≥0.75:1 to ≤1.5:1

In one embodiment, the inorganic filler may include at least one of fused silica, crystalline silica, calcium carbonate, magnesium carbonate, alumina, magnesia, clay, talc, calcium silicate, titanium oxide, antimony oxide, and glass fiber.

In one embodiment, the epoxy resin composition may further include at least one of colorants, coupling agents,

release agents, stress-relieving agents, cross-linking enhancers, leveling agents, and flame retardants.

A further aspect of the present invention relates to a semiconductor device encapsulated with the epoxy resin composition.

## Detailed Description of the Invention

Embodiments of the present invention will now be described in detail.

In one aspect of the present invention, a quaternary phosphonium salt is represented by Formula 1:

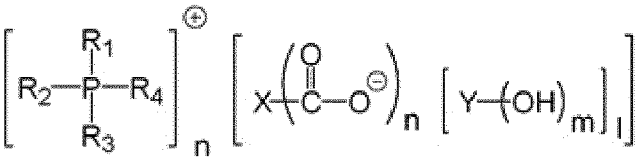

(1)

wherein R1, R2, R3 and R4 are each independently an unsubstituted benzene group; X is an unsubstituted benzene group; Y is an unsubstituted benzene group, a naphtalene group or a Si substituted with one to three unsubstituted benzene groups; n is 2; m is an integer from 1 to 6; 1 is a number greater than 0 to 6, provided that when Y is Si, the sum of m and the number of the substituents is a maximum of 4.

The term "substituted" used herein means that at least one hydrogen atom is substituted with a halogen atom, a hydroxyl group, a $C_1$-$C_{10}$ alkyl group, a $C_1$-$C_{10}$ haloalkyl group, a $C_6$-$C_{10}$ aryl group, a $C_1$-$C_{10}$ alkoxy group, or a combination thereof. The term "alkyl group" as used herein refers to a linear or branched alkyl group, unless otherwise specified. The term "hydrocarbon group" used herein refers to a linear, branched or cyclic saturated or unsaturated hydrocarbon group, unless otherwise specified. The term "branched" means the presence of two or more carbon atoms, the term "cyclic" means the presence of four or more carbon atoms, and the term "heteroatom" means the presence of at least one atom of oxygen (O), sulfur (S), and nitrogen (N) atoms.

There is no restriction on the method of preparing the quaternary phosphonium salt. For example, the quaternary phosphonium salt may be prepared by dissolving a carboxylic acid compound corresponding to the carboxylate anion moiety of Formula 1 in a basic solution such as an aqueous sodium hydroxide (NaOH) solution, adding a solution of a hydroxyl compound corresponding to the hydroxyl moiety of Formula 1 and a halogenated quaternary phosphonium corresponding to the quaternary phosphonium cation moiety of Formula 1 in an alcohol such as methanol, allowing the mixture to react for about 1 hour, and drying the resulting precipitate, as will be described in the following preparative examples.

In one embodiment, the quaternary phosphonium salt may be any one of the compounds represented by Formulas 1a to 1k:

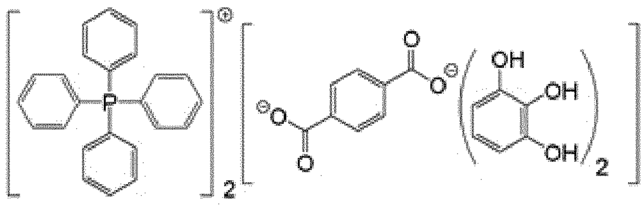

(1a)

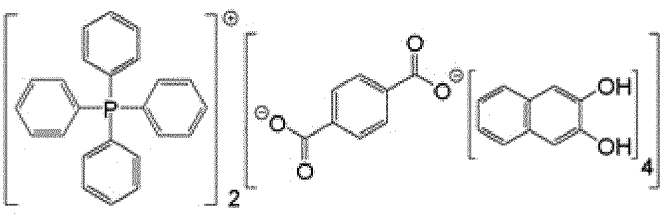

(1b)

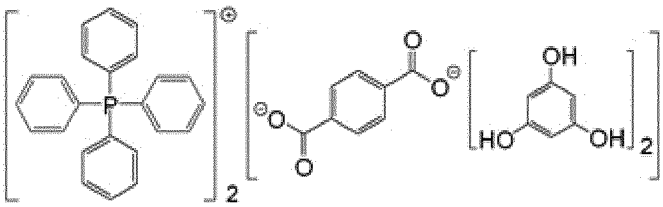

(1c)

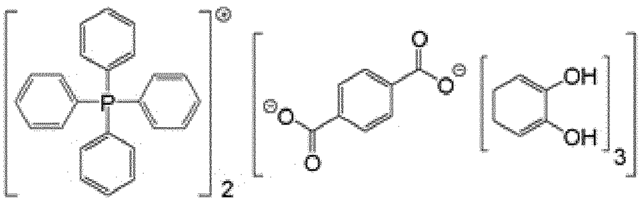

(1d)

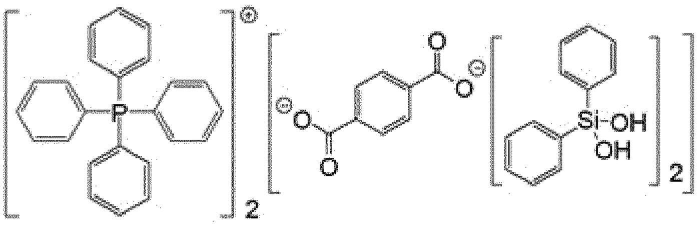

(1e)

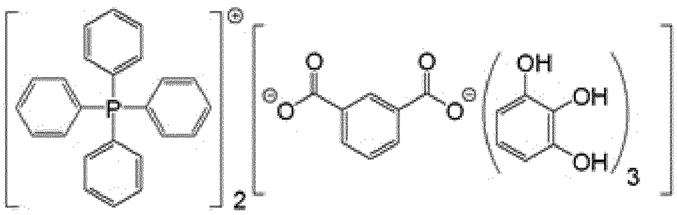

(1f)

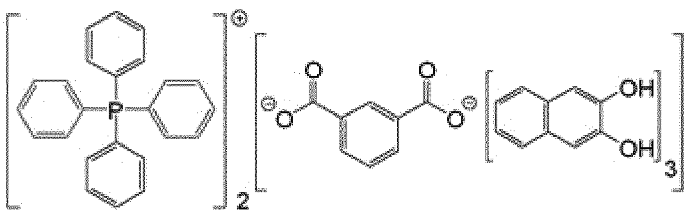

(1g)

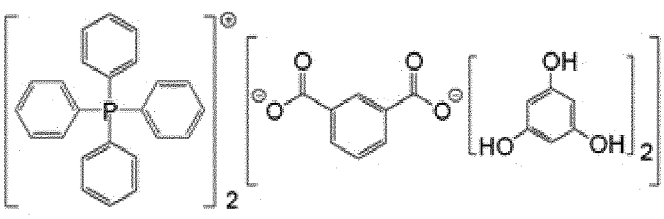

(1h)

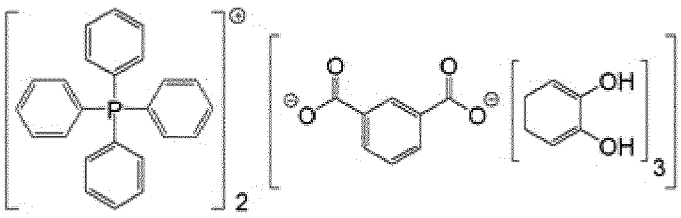

(1i)

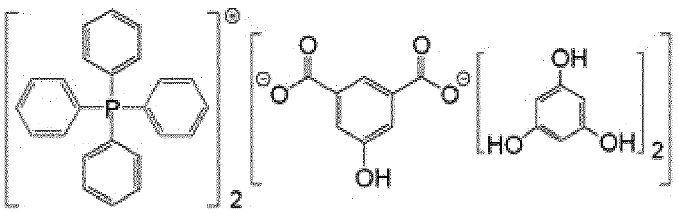

(1j)

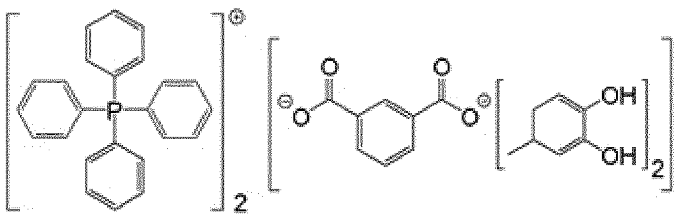

(1k)

In another aspect of the present invention, an epoxy resin composition includes an epoxy resin, a curing agent, a curing accelerator, and an inorganic filler. The epoxy resin composition is useful in encapsulating a semiconductor device.

**Epoxy resin**

The epoxy resin may be any of those commonly used in the field of epoxy resin compositions for encapsulating semiconductor devices. Any epoxy resin having two or more epoxy groups in the molecule may be used without particular limitation in the present invention. For example, the epoxy resin may be an epoxy monomer, an epoxy oligomer, an epoxy polymer, or a combination thereof.

Specific examples of epoxy resins suitable for use in the present invention include, but are not limited to, epoxy resins obtained by epoxidation of condensation products of phenol or alkyl phenols and hydroxybenzaldehyde, phenol novolac type epoxy resins, cresol novolac type epoxy resins, polyfunctional epoxy resins, naphthol novolac type epoxy resins, novolac type epoxy resins of bisphenol A/bisphenol F/bisphenol AD, glycidyl ethers of bisphenol A/bisphenol F/bisphenol AD, bishydroxybiphenyl-based epoxy resins, dicyclopentadiene-based epoxy resins, biphenyl type epoxy resins, polycyclic aromatic-modified epoxy resins, bisphenol A type epoxy resins, ortho-cresol novolac type epoxy resins, phenol aralkyl type epoxy resins, and naphthalene-based epoxy resins. These epoxy resins may be used alone or in combination of two or more thereof.

The epoxy resin serves to impart excellent mechanical properties to the epoxy resin composition. Examples of such epoxy resins include, but are not limited to: a phenol aralkyl type epoxy resin having a novolac structure including at least one biphenyl moiety in the molecule, as represented by Formula 2:

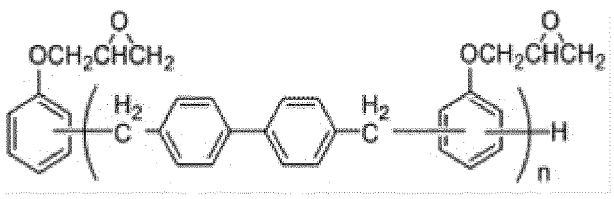

(2)

wherein n is an average of 1 to 7;

a biphenyl type epoxy resin represented by Formula 3:

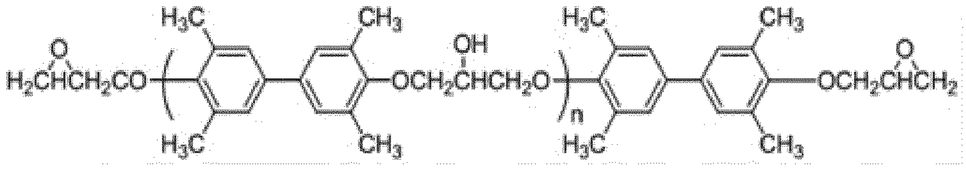

(3)

wherein n is an average of 0 to 7;
a xyloc type epoxy resin represented by Formula 4:

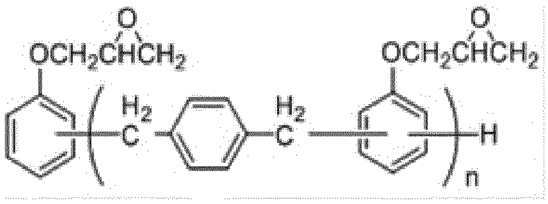

(4)

wherein n is an average of 1 to 7; and
a polyfunctional epoxy resin including naphthalene skeletons, represented by Formula 5:

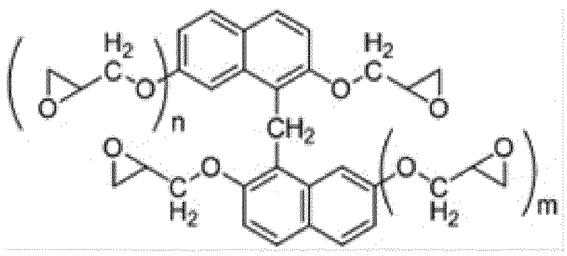

(5)

wherein m and n are each independently an average of 0 to 6.

These epoxy resins may be used alone or in combination.

In one embodiment, the epoxy resin may also be used in the form of an adduct, for example, a melt master batch obtained by pre-reacting with the curing agent, the curing accelerator, and optionally one or more additives such as a release agent or a coupling agent.

The epoxy resin may be present in an amount of ≥1% to ≤20% by weight, preferably ≥1% to ≤13% by weight, more preferably ≥1.2% to ≤10% by weight, based on the total weight of the epoxy resin composition. Within this range, good room temperature storage stability, sufficient flowability, and high curability of the epoxy resin composition can be ensured.

<u>**Curing agent**</u>

The curing agent may be any of those commonly used for the encapsulation of semiconductor devices. The curing agent is not particularly limited so long as it has two or more phenolic hydroxyl or amino groups. The curing agent may be a monomer, an oligomer, a polymer, or a combination thereof.

Specific examples of curing agents suitable for use in the present invention include, but are not limited to, phenol aralkyl type phenolic resins, xyloc type phenolic resins, phenol novolac type phenolic resins, cresol novolac type phenolic resin, naphthol type phenolic resins, terpene type phenolic resins, polyfunctional phenolic resins, polycyclic aromatic phenolic resins, dicyclopentadiene-based phenolic resins, terpene-modified phenolic resins, dicyclopentadiene-modified phenolic resin, novolac type phenolic resins synthesized from bisphenol A and resorcinol, polyhydric phenolic compounds, including tris(hydroxyphenyl)methane and dihydroxybiphenyl, acid anhydrides, including maleic anhydride and phthalic anhydride, and aromatic amines, including metaphenylenediamine, diaminodiphenylmethane and diaminodiphenylsulfone.

Preferably, the curing agent may be a phenol aralkyl type phenolic resin having at least one biphenyl skeleton,

as represented by Formula 6, a xyloc type phenolic resin represented by Formula 7, or combinations thereof.

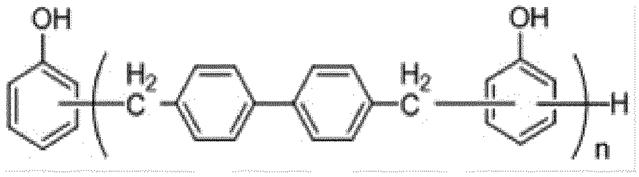

(6)

In Formula 6, n is an average of 1 to 7.

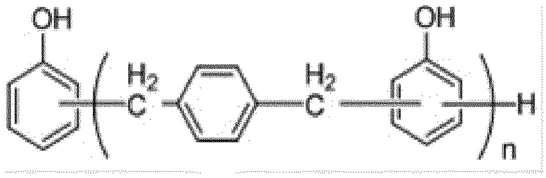

(7)

In Formula 7, n is an average of 1 to 7, and combinations thereof.

In one embodiment, the curing agents may be used alone or in combination with one or two other components. For example, the curing agent may also be used in the form of an adduct, for example, a melt master batch obtained by pre-reacting with the epoxy resin, the curing accelerator, and other additives.

The curing agent may have a softening point of 50 °C to 100 °C, preferably 60 °C to 90 °C. Within this range, the viscosity of the resin composition is appropriate so that the flowability of the resin composition can be prevented from deteriorating.

The phenolic hydroxyl or amine equivalent weight of the curing agent may be from 90 g/eq. to 300 g/eq, but is not limited to this range.

The curing agent may be present in an amount of ≥1% to ≤20% by weight, preferably ≥1.5% to ≤10% by weight, more preferably ≥2% to ≤8% by weight, based on the total weight of the epoxy resin composition. Within this range, appreciable amounts of the epoxy groups and phenolic hydroxyl or amino groups do not remain unreacted, ensuring high reliability of the epoxy resin composition.

The epoxy resin and the curing agent may be present in such amounts that the ratio of the epoxy equivalent weight of the epoxy resin to the phenolic hydroxyl or amine equivalent weight of the curing agent is from ≥0.5:1 to ≤2:1, preferably ≥0.8:1 to ≤1.6:1. Within this range, sufficient flowability of the resin composition can be ensured and curing time need not be extended.

## Curing accelerator

The curing accelerator serves to promote the reaction between the epoxy resin and the curing agent and includes the quaternary phosphonium salt represented by Formula 1.

The curing accelerator represented by Formula 1 is in the form of a salt of a quaternary phosphonium. The curing accelerator is highly stable during storage at room temperature (25 °C) and a humidity of 50% and is sufficiently flowable during molding. When a curing reaction occurs, the hydrogen bond between the carboxylic acid anion and the (phenolic) hydroxyl group derived from different molecules is cleaved rapidly. This bond cleavage causes a significant increase in the degree of freedom of the phosphonium cation as a catalytic moiety, which allows fast curing and ensures excellent curing properties such as high cure strength.

The curing accelerator may be combined with one or more other curing accelerators selected from tertiary amines, organometallic compounds, organophosphorus compounds, imidazole compounds, and boron compounds, which are those well known in the art. The curing accelerator may also be used in the form of an adduct obtained by pre-reacting with the epoxy resin and/or the curing agent.

The curing accelerator may be present in an amount of ≥0.001% to ≤2% by weight, preferably ≥0.001% to ≤1.5% by weight, more preferably ≥0.01% to ≤1% by weight, based on the total weight of the epoxy resin composition. Within this range, good room temperature storage stability of the epoxy resin composition is obtained, curing time need not be extended, and sufficient flowability of the composition can be ensured.

## Inorganic filler

The inorganic filler is used to improve the mechanical properties of the epoxy resin composition and to reduce

stress in the epoxy resin composition. The inorganic filler may be any of those commonly used in epoxy resin compositions for encapsulating semiconductor devices. Specific examples of inorganic fillers suitable for use in the present invention include, but are not limited to, fused silica, crystalline silica, calcium carbonate, magnesium carbonate, alumina, magnesia, clay, talc, calcium silicate, titanium oxide, antimony oxide, and glass fiber. These inorganic fillers may be used alone or as a mixture of two or more thereof.

The use of fused silica having a low coefficient of linear expansion is preferred in terms of stress reduction. The fused silica refers to amorphous silica having a specific gravity not higher than 2.3. The fused silica may be prepared by melting crystalline silica or may include amorphous silica products synthesized from various raw materials.

The shape and particle diameter of the inorganic filler are not particularly limited. For example, the average particle diameter of the inorganic filler may be from ≥0.001 μm to ≤30 μm. The inorganic filler is preferably spherical fused silica having an average particle diameter of ≥0.001 μm to ≤30 μm. The inorganic filler may also be a mixture of spherical fused silica products having different particle diameters. For example, the inorganic filler may be a mixture of ≥50% to ≤99% by weight of spherical fused silica having an average particle diameter of ≥5 μm to ≤30 μm and ≥1% to ≤50% by weight of spherical fused silica having an average particle diameter of ≥0.001 μm to ≤1 μm. The particle diameter of the inorganic filler may also be adjusted to a maximum of 45 μm, 55 μm or 75 μm depending on the application of the epoxy resin composition.

Before use, the inorganic filler may be surface treated with at least one coupling agent selected from epoxysilanes, aminosilanes, mercaptosilanes, alkylsilanes and alkoxysilanes.

The inorganic filler may be included in an appropriate amount depending on the desired physical properties of the epoxy resin composition, for example, moldability, low-stress properties, and high-temperature strength. For example, the inorganic filler may be present in an amount of ≥70% to ≤95% by weight, preferably ≥75% to ≤94% by weight, more preferably ≥82% to ≤92% by weight, based on the total weight of the epoxy resin composition. Within this range, good resistance to warpage, flowability and moldability of the epoxy resin composition can be obtained and high reliability of a package can be expected.

**Additives**

The epoxy resin composition of the present invention may optionally further include one or more additives such as colorants, coupling agents, release agents, stress-relieving agents, cross-linking enhancers, leveling agents, flame retardants and the like.

Examples of the colorants include, but are not limited to, carbon black, organic dyes, and inorganic dyes.

The coupling agents may be silane coupling agents. Examples of the silane coupling agents include, but are not limited to, epoxysilanes, aminosilanes, mercaptosilanes, alkylsilanes, and alkoxysilanes.

Examples of the release agents include, but are not limited to, paraffin-based waxes, ester-based waxes, higher fatty acids, metal salts of higher fatty acids, natural fatty acids, and metal salts of natural fatty acids.

Examples of the stress-relieving agents include, but are not limited to, modified silicone oils, silicone elastomers, silicone powders, and silicone resins.

The flame retardants may be non-halogenated (organic and inorganic) flame retardants. Examples of the non-halogenated flame retardants include, but are not limited to, phosphazene, zinc borate, aluminum hydroxide, and magnesium hydroxide.

The additives may be included in an amount of ≥0% to ≤15% by weight, preferably ≥0.1% to ≤5.5% by weight, based on the total weight of the epoxy resin composition. Particularly, the flame retardant may be included in an appropriate amount depending on the flame retardancy of the epoxy resin composition, which is determined by various factors, for example, the content of the inorganic filler and the kind of the curing agent. For example, when the flame retardant may be included in an amount of ≥0% to ≤10% by weight, preferably ≥0% to ≤8% by weight, more preferably ≥0% to ≤5% by weight, based on the total weight of the epoxy resin composition.

There is no particular restriction on the method of preparing the epoxy resin composition of the present invention. For example, the epoxy resin composition may be prepared by the following procedure. First, all components of the resin composition are homogenized using a suitable mixer, such as a Henschel mixer or a Redige mixer. Then, the mixture is melt-kneaded in a roll mill or a kneader at ≥90 °C to ≤120 °C, cooled, and pulverized.

In another aspect of the present invention, a semiconductor device is encapsulated with the epoxy resin composition. For example, the semiconductor device may be encapsulated with the epoxy resin composition by various molding processes, such as low-pressure transfer molding, compression molding, injection molding, and casting molding. Low-pressure transfer molding is preferred. Examples of semiconductor devices that can be fabricated by the molding processes may include copper lead frames, iron lead frames, copper or iron lead frames pre-plated with at least one of nickel, copper and palladium, organic laminate frames, and the like.

Next, the present invention will be explained in more detail with reference to some examples. It should be understood that these examples are provided for illustration only and are not to be in any way construed as limiting the

present invention.

Descriptions of details apparent to those skilled in the art will be omitted.

## EXAMPLES

### Preparative Example 1: Preparation of quaternary phosphonium salt represented by Formula 1a

19.8 g of terephthalic acid was dissolved in 237 mL of a 1 M aqueous NaOH solution. To the solution was slowly added a solution of 30.1 g of pyrogallol and 100 g of tetraphenylphosphonium bromide in 100 mL of methanol. The mixture was allowed to react for 1 h. The resulting precipitate was filtered and dried to afford 106 g of the quaternary phosphonium salt represented by Formula 1a as a pale brown solid.

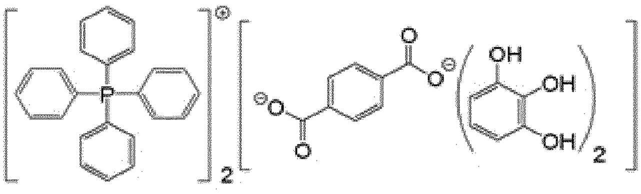

(1a)

### Preparative Example 2: Preparation of quaternary phosphonium salt represented by Formula 1b

19.8 g of terephthalic acid was dissolved in 237 mL of a 1 M aqueous NaOH solution. To the solution was slowly added a solution of 76.4 g of 2,3-dihydroxynaphthalene and 100 g of tetraphenylphosphonium bromide in 100 mL of methanol. The mixture was allowed to react for 1 h. The resulting precipitate was filtered and dried to afford 152 g of the quaternary phosphonium salt represented by Formula 1b as a pale brown solid.

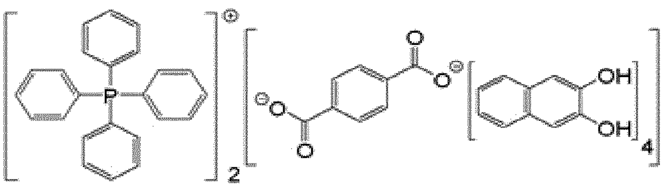

(1b)

### Preparative Example 3: Preparation of quaternary phosphonium salt represented by Formula 1c

19.8 g of terephthalic acid was dissolved in 237 mL of a 1 M aqueous NaOH solution. To the solution was slowly added a solution of 30.1 g of phloroglucinol and 100 g of tetraphenylphosphonium bromide in 100 mL of methanol. The mixture was allowed to react for 1 h. The resulting precipitate was filtered and dried to afford 148 g of the quaternary phosphonium salt represented by Formula 1c as a pale brown solid.

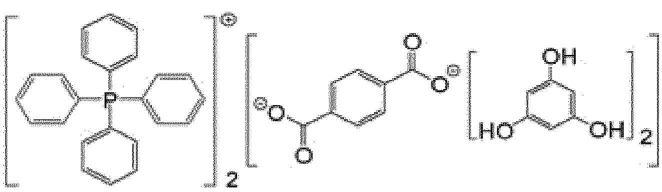

(1c)

### Preparative Example 4: Preparation of quaternary phosphonium salt represented by Formula 1d

19.8 g of terephthalic acid was dissolved in 237 mL of a 1 M aqueous NaOH solution. To the solution was slowly added a solution of 39.3 g of catechol and 100 g of tetraphenylphosphonium bromide in 100 mL of methanol. The mixture was allowed to react for 1 h. The resulting precipitate was filtered and dried to afford 115 g of the quaternary phosphonium salt represented by Formula 1d as a pale brown solid.

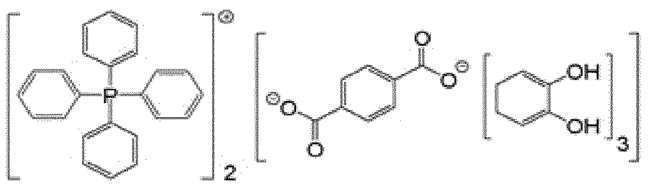

(1d)

**Preparative Example 5: Preparation of quaternary phosphonium salt represented by Formula 1e**

19.8 g of terephthalic acid was dissolved in 237 mL of a 1 M aqueous NaOH solution. To the solution was slowly added a solution of 53.2 g of diphenylsilanediol and 100 g of tetraphenylphosphonium bromide in 100 mL of methanol. The mixture was allowed to react for 1 h. The resulting precipitate was filtered and dried to afford 146 g of the quaternary phosphonium salt represented by Formula 1e as a pale brown solid.

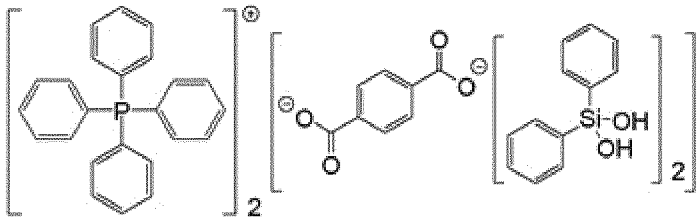

(1e)

**Preparative Example 6: Preparation of quaternary phosphonium salt represented by Formula 1f**

19.8 g of isophthalic acid was dissolved in 237 mL of a 1 M aqueous NaOH solution. To the solution was slowly added a solution of 45.2 g of pyrogallol and 100 g of tetraphenylphosphonium bromide in 100 mL of methanol. The mixture was allowed to react for 1 h. The resulting precipitate was filtered and dried to afford 116 g of the quaternary phosphonium salt represented by Formula If as a pale brown solid.

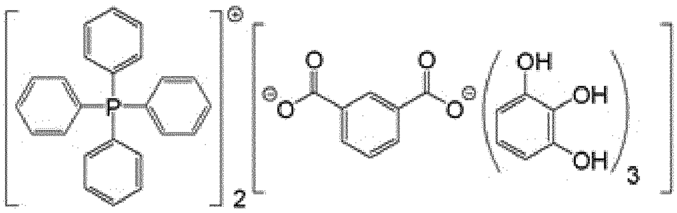

(1f)

**Preparative Example 7: Preparation of quaternary phosphonium salt represented by Formula 1g**

19.8 g of isophthalic acid was dissolved in 237 mL of a 1 M aqueous NaOH solution. To the solution was slowly added a solution of 57.3 g of 2,3-dihydroxynaphthalene and 100 g of tetraphenylphosphonium bromide in 100 mL of methanol. The mixture was allowed to react for 1 h. The resulting precipitate was filtered and dried to afford 122 g of the quaternary phosphonium salt represented by Formula 1g as a pale brown solid.

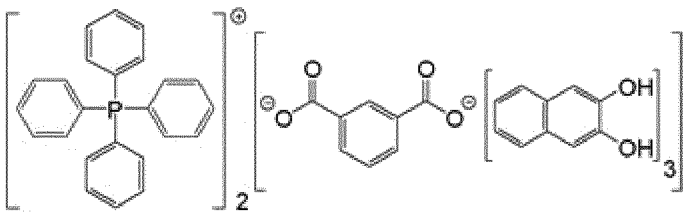

(1g)

**Preparative Example 8: Preparation of quaternary phosphonium salt represented by Formula 1h**

19.8 g of isophthalic acid was dissolved in 237 mL of a 1 M aqueous NaOH solution. To the solution was slowly added a solution of 60.2 g of phloroglucinol and 100 g of tetraphenylphosphonium bromide in 100 mL of methanol. The mixture was allowed to react for 1 h. The resulting precipitate was filtered and dried to afford 108 g of the quaternary phosphonium salt represented by Formula 1h as a pale brown solid.

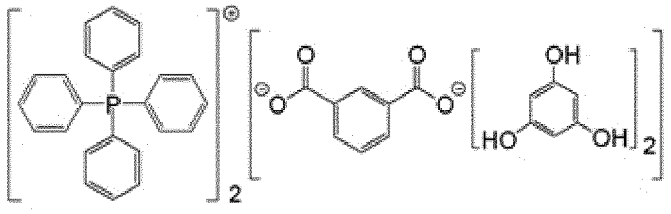

(1h)

**Preparative Example 9: Preparation of quaternary phosphonium salt represented by Formula 1i**

19.8 g of isophthalic acid was dissolved in 237 mL of a 1 M aqueous NaOH solution. To the solution was slowly added a solution of 39.3 g of catechol and 100 g of tetraphenylphosphonium bromide in 100 mL of methanol. The mixture was allowed to react for 1 h. The resulting precipitate was filtered and dried to afford 115 g of the quaternary phosphonium salt represented by Formula 1i as a pale brown solid.

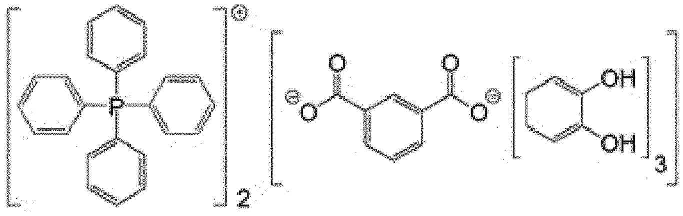

(1i)

**Preparative Example 10: Preparation of quaternary phosphonium salt represented by Formula 1j**

21.7 g of 5-hydroxyisophthalic acid was dissolved in 237 mL of a 1 M aqueous NaOH solution. To the solution was slowly added a solution of 30.1 g of phloroglucinol and 100 g of tetraphenylphosphonium bromide in 100 mL of methanol. The mixture was allowed to react for 1 h. The resulting precipitate was filtered and dried to afford 108 g of the quaternary phosphonium salt represented by Formula 1j as a pale brown solid.

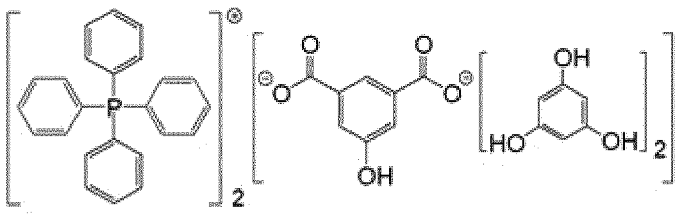

(1j)

**Preparative Example 11: Preparation of quaternary phosphonium salt represented by Formula 1k**

19.8 g of isophthalic acid was dissolved in 237 mL of a 1 M aqueous NaOH solution. To the solution was slowly added a solution of 30.0 g of 4-methylcatechol and 100 g of tetraphenylphosphonium bromide in 100 mL of methanol. The mixture was allowed to react for 1 h. The resulting precipitate was filtered and dried to afford 101 g of the quaternary phosphonium salt represented by Formula 1k as a pale brown solid.

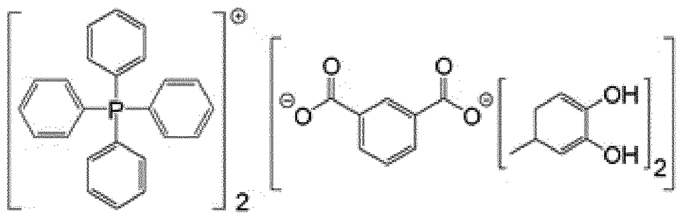
(1k)

Details of components used in Examples 1 to 11 and Comparative Examples 1 and 2 are as follows:

(A) Epoxy resin

A phenol aralkyl type epoxy resin (NC-3000, Nippon Kayaku) was used.

(B) Curing agent

A xyloc type phenolic resin (HE100C-10, Air Water) was used.

(C) Curing accelerators
(C1)-(C11): The quaternary phosphonium salts prepared in Preparative Examples 1-11 were used, respectively.
(C12): Triphenylphosphine was used.
(C13): An adduct of triphenylphosphine and 1,4-benzoquinone was used.
(D) Inorganic filler: A mixture of spherical fused silica having an average particle diameter of 18 μm and spherical fused silica having an average particle diameter of 0.5 μm in a weight ratio of 9:1 was used.
(E) Coupling agent

A mixture of (e1) mercaptopropyltrimethoxysilane (KBM-803, Shinetsu) and (e2) methyltrimethoxysilane (SZ-6070, Dow Corning Chemical) was used.

(F) Additives
(f1): Carnauba wax was used as a release agent
(f2): Carbon black (MA-600, Matsushita Chemical) was used as a colorant.

**Examples 1-11 and Comparative Examples 1-2**

The components were weighed as shown in Table 1 and homogenized using a Henschel mixer to prepare first powdery compositions. Then, each of the compositions was melt-kneaded using a continuous kneader at 95 °C, cooled, and pulverized to prepare an epoxy resin composition for the encapsulation of a semiconductor device.

**TABLE 1**

| | | Example | | | | | | | | | | | Comparative Example | |
|---|---|---|---|---|---|---|---|---|---|---|---|---|---|---|
| | | 1 | 2 | 3 | 4 | 5 | 6 | 7 | 8 | 9 | 10 | 11 | 1 | 2 |
| (A) | | 8.69 | 8.69 | 8.69 | 8.69 | 8.69 | 8.69 | 8.69 | 8.69 | 8.69 | 8.69 | 8.69 | 8.69 | 8.69 |
| (B) | | 5.01 | 5.01 | 5.01 | 5.01 | 5.01 | 5.01 | 5.01 | 5.01 | 5.01 | 5.01 | 5.01 | 5.01 | 5.01 |
| (C) | C1 | 0.3 | - | - | - | - | - | - | - | - | - | - | - | - |
| | C2 | - | 0.3 | - | - | - | - | - | - | - | - | - | - | - |
| | C3 | - | - | 0.3 | - | - | - | - | - | - | - | - | - | - |

(continued)

| | | Example | | | | | | | | | | | Comparative Example | |
|---|---|---|---|---|---|---|---|---|---|---|---|---|---|---|
| | | 1 | 2 | 3 | 4 | 5 | 6 | 7 | 8 | 9 | 10 | 11 | 1 | 2 |
| | C4 | - | - | - | 0.3 | - | - | - | - | - | - | - | - | - |
| | C5 | - | - | - | - | 0.3 | - | - | - | - | - | - | - | - |
| | C6 | - | - | - | - | - | 0.3 | - | - | - | - | - | - | - |
| | C7 | - | - | - | - | - | - | 0.3 | - | - | - | - | - | - |
| | C8 | - | - | - | - | - | - | - | 0.3 | - | - | - | - | - |
| | C9 | - | - | - | - | - | - | - | - | 0.3 | - | - | - | - |
| | C10 | - | - | - | - | - | - | - | - | - | 0.3 | - | - | - |
| | C11 | - | - | - | - | - | - | - | - | - | - | 0.3 | - | - |
| | C12 | - | - | - | - | - | - | - | - | - | - | - | 0.3 | - |
| | C13 | - | - | - | - | - | - | - | - | - | - | - | - | 0.3 |
| (D) | | 85 | 85 | 85 | 85 | 85 | 85 | 85 | 85 | 85 | 85 | 85 | 85 | 85 |
| (E) | (e1) | 0.2 | 0.2 | 0.2 | 0.2 | 0.2 | 0.2 | 0.2 | 0.2 | 0.2 | 0.2 | 0.2 | 0.2 | 0.2 |
| | (e2) | 0.2 | 0.2 | 0.2 | 0.2 | 0.2 | 0.2 | 0.2 | 0.2 | 0.2 | 0.2 | 0.2 | 0.2 | 0.2 |
| (F) | (f1) | 0.3 | 0.3 | 0.3 | 0.3 | 0.3 | 0.3 | 0.3 | 0.3 | 0.3 | 0.3 | 0.3 | 0.3 | 0.3 |
| | (f2) | 0.3 | 0.3 | 0.3 | 0.3 | 0.3 | 0.3 | 0.3 | 0.3 | 0.3 | 0.3 | 0.3 | 0.3 | 0.3 |

Methods for evaluation of physical properties

(1) Flowability (inches): The flow length of each of the epoxy resin compositions was measured using a transfer molding press in a testing mold at 175 °C and 70 kgf/cm$^2$ in accordance with EMMI-1-66. A higher measured value indicates better flowability.

(2) Curing shrinkage (%): Each of the epoxy resin compositions was molded using a transfer molding press in an ASTM mold for flexural strength specimen construction at 175 °C and 70 kgf/cm$^2$ to obtain a molded specimen (125 × 12.6 × 6.4 mm). The specimen was subjected to post-molding cure (PMC) in an oven at 170-180 °C for 4 h. After cooling, the length of the specimen was measured using calipers. The curing shrinkage of the epoxy resin composition was calculated by Equation 1:

$$\text{Curing Shrinkage} = (\text{Length of the mold at 175 °C} - \text{Length of the specimen}) \div (\text{Length of the mold at 175 °C}) \times 100 \qquad (1)$$

(3) Glass transition temperature (°C) was measured using a thermomechanical analyzer (TMA) while heating at a rate of 10 °C/min from 25 °C to 300 °C.

(4) Moisture absorption (%): Each of the resin compositions prepared in Examples 1-11 and Comparative Examples 1-2 was molded at a mold temperature of 170-180 °C, a clamp pressure of 70 kg/cm$^2$, a transfer pressure of 1,000 psi and a transfer speed of 0.5-1 cm/s for a curing time of 120 sec to obtain a cured specimen in the form of a disc having a diameter of 50 mm and a thickness of 1 mm. The specimen was subjected to post-molding cure (PMC) in an oven at 170-180 °C for 4 h and allowed to stand at 85 °C and 85 RH% for 168 h. The weights of the specimen before and after moisture absorption were measured. The moisture absorption of the resin composition was calculated by Equation 2:

$$\text{Moisture absorption (\%)} = (\text{Weight of the specimen after moisture absorption} - \text{Weight of the specimen before moisture absorption}) \div (\text{Weight of the specimen before moisture absorption}) \times 100 \qquad (2)$$

(5) Adhesive strength (kgf): A copper metal device having a specification adapted to a mold for adhesive strength measurement was prepared as a test piece. Each of the resin compositions prepared in Examples 1-11 and Comparative Examples 1-2 was molded on the test piece at a mold temperature of 170-180 °C, a clamp pressure of 70 $kgf/cm^2$, a transfer pressure of 1,000 psi and a transfer speed of 0.5-1 cm/s for a curing time of 120 sec to obtain a cured specimen. The specimen was subjected to post-molding cure (PMC) in an oven at 170-180 °C for 4 h. The area of the epoxy resin composition in contact with the specimen was 40 ± 1 $mm^2$. The adhesive strength of the epoxy resin composition was measured using a universal testing machine (UTM). 12 specimens of each composition were produced. After the measurement procedure was repeated, the measured adhesive strength values were averaged.

(6) Room temperature storage stability (%): The flowability of each of the epoxy resin compositions was measured in accordance with the method described in (1). After storage at 25 °C and a humidity of 50% for 3 days, the flowability of the epoxy resin composition was measured. The room temperature storage stability of the epoxy resin composition was calculated by substituting the flowabilities into Expression 3:

$$\text{Room temperature storage stability} = (\text{Flowability measured after storage at 25 °C and a humidity of 50\% for 3 days}) \div (\text{Flowability measured immediately after preparation}) \times 100 \qquad (3)$$

A higher value indicates better room temperature storage stability.

(7) Degree of cure (Shore-D): Each of the epoxy resin compositions was cured using a multi plunger system (MPS) equipped with a mold at 175 °C for 50 sec, 60 sec, 70 sec, 80 sec, and 90 sec to construct exposed thin quad flat packages (eTQFPs), each including a copper metal device having a width of 20 mm, a length of 20 mm and a thickness of 1 mm. The hardness values of the cured products in the packages on the mold according to the curing periods of time were directly measured using a Shore D durometer. A higher hardness value indicates better degree of cure.

(8) Reliability: The eTQFP package for the evaluation of degree of cure (curing time 90 sec) was dried at 125 °C for 24 h. After 5 cycles of thermal shock testing (1 cycle refers to a series of exposures of the package to -65 °C for 10 min, 25 °C for 10 min, and 150 °C for 10 min), the package was allowed to stand at 85 °C and 60% RH for 168 h and treated by IR reflow three times at 260 °C for 30 sec (preconditioning). After preconditioning, the occurrence of external cracks in the package was observed using an optical microscope, and the occurrence of peeling between the epoxy resin composition and a lead frame was evaluated by scanning acoustic microscopy (C-SAM) as a nondestructive testing method. External cracks of the package or peeling between the epoxy resin composition and the lead frame mean that reliability of the package cannot be guaranteed.

The physical properties of the epoxy resin compositions prepared in Examples 1-11 and Comparative Examples 1-2 were evaluated by the above methods, and the results are shown in Table 2.

**TABLE 2**

| | | | Example | | | | | | | | | | | Comparative Example | |
|---|---|---|---|---|---|---|---|---|---|---|---|---|---|---|---|
| | | | 1 | 2 | 3 | 4 | 5 | 6 | 7 | 8 | 9 | 10 | 11 | 1 | 2 |
| Basic physical properties | Flowability (inch) | | 72 | 74 | 70 | 72 | 72 | 71 | 73 | 70 | 70 | 71 | 74 | 52 | 58 |
| | Curing shrinkage (%) | | 0.35 | 0.33 | 0.35 | 0.27 | 0.30 | 0.36 | 0.33 | 0.35 | 0.34 | 0.35 | 0.35 | 0.42 | 0.40 |
| | Glass transition temp. (°C) | | 124 | 124 | 123 | 124 | 123 | 123 | 125 | 125 | 121 | 126 | 123 | 121 | 122 |
| | Moisture absorption (%) | | 0.25 | 0.25 | 0.24 | 0.25 | 0.22 | 0.24 | 0.25 | 0.28 | 0.26 | 0.27 | 0.24 | 0.25 | 0.26 |
| | Adhesive strength (kgf) | | 75 | 76 | 74 | 77 | 75 | 74 | 75 | 74 | 76 | 77 | 79 | 72 | 74 |
| | Room temperature storage | | 94 | 92 | 90 | 91 | 89 | 88 | 92 | 91 | 91 | 90 | 91 | 48 | 53 |
| | stability (%) | | | | | | | | | | | | | | |
| Evaluation of packages | Degree of cure (Shore-D) according to curing time | 50 sec | 71 | 68 | 70 | 70 | 70 | 71 | 68 | 69 | 70 | 71 | 70 | 52 | 60 |
| | | 60 sec | 74 | 70 | 74 | 73 | 73 | 74 | 71 | 71 | 72 | 73 | 72 | 60 | 67 |
| | | 70 sec | 75 | 74 | 76 | 73 | 73 | 75 | 72 | 73 | 75 | 73 | 75 | 64 | 69 |
| | | 80 sec | 76 | 74 | 76 | 74 | 74 | 75 | 73 | 74 | 75 | 74 | 75 | 65 | 70 |
| | | 90 sec | 77 | 74 | 76 | 75 | 74 | 75 | 74 | 76 | 75 | 75 | 76 | 65 | 71 |
| | Reliability | Number of external cracks | 0 | 0 | 0 | 0 | 0 | 0 | 0 | 0 | 0 | 0 | 0 | 0 | 0 |
| | | Number of peelings | 0 | 0 | 0 | 0 | 0 | 0 | 0 | 0 | 0 | 0 | 0 | 48 | 22 |
| | | Number of semiconductors tested | 88 | 88 | 88 | 88 | 88 | 88 | 88 | 88 | 88 | 88 | 88 | 88 | 88 |
| | | | | | | | | | | | | | | | |

As can be seen from the results in Table 2, the epoxy resin compositions of Examples 1-11 had higher flowabilities, lower curing shrinkages, and better room temperature storage stabilities than the epoxy resin compositions of Comparative Examples 1-2. Further, the epoxy resin compositions of Examples 1-11 showed higher degrees of cure even in shorter curing periods of time. Further, no external cracks were observed in the packages using the epoxy resin compositions of Examples 1-11, indicating that the epoxy resin compositions had good crack resistance. Peeling was not observed between the epoxy resin compositions of Examples 1-11 and the lead frames, indicating that the epoxy resin compositions had very good moisture resistance reliability.

Although some embodiments have been described herein, it will be apparent to those skilled in the art that these embodiments are given by way of illustration only, and that various modifications, changes, alterations, and equivalent embodiments can be made.

The scope of the invention should be limited only by the accompanying claims and equivalents thereof.

**Claims**

1. A quaternary phosphonium salt represented by Formula 1:

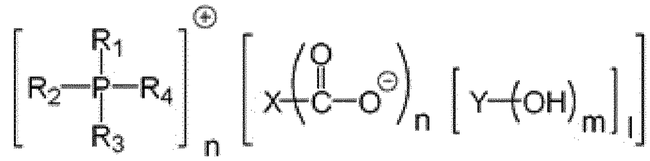

(1)

wherein $R_1$, $R_2$, $R_3$, and $R_4$ are each an unsubsituted benzene group.; X is a unsubsituted benzene group.; Y is a unsubsituted benzene group, a naphtalene group or a Si substituted with one to three unsubsituted benzene groups; n is 2, m is an integer from 1 to 6; 1 is a number greater than 0 to 6, provided that when Y is Si, the sum of m and the number of the substituents is a maximum of 4.

2. The quaternary phosphonium salt according to claim 1, wherein m is 2 or 3.

3. The quaternary phosphonium salt according to claim 1, wherein 1 is 2, 3, or 4.

4. The quaternary phosphonium salt according to claim 1, wherein the quaternary phosphonium salt is any one of the compounds represented by Formulas 1a to 1k:

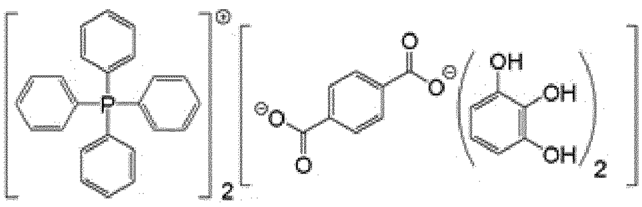

(1a)

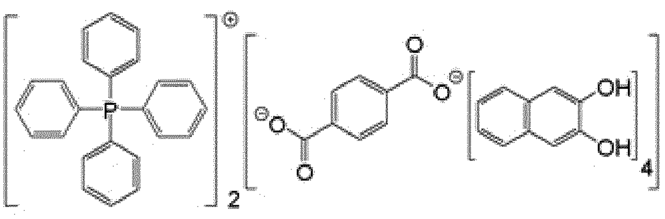

(1b)

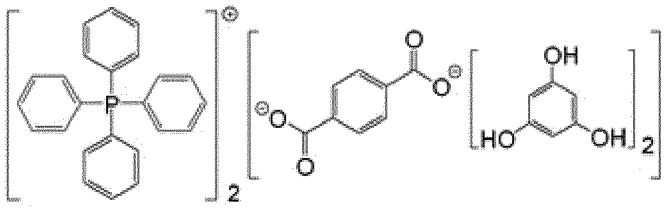

(1c)

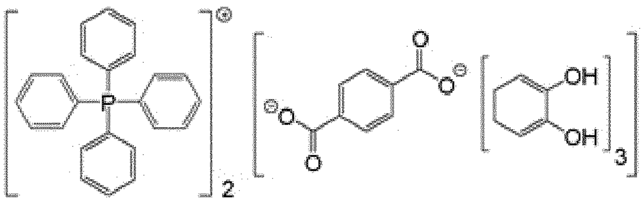

(1d)

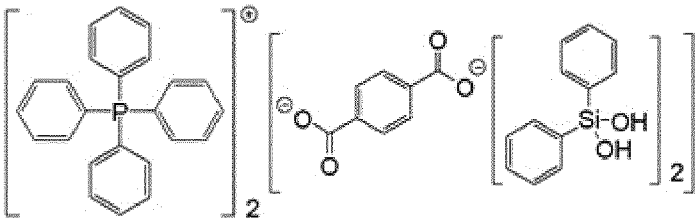

(1e)

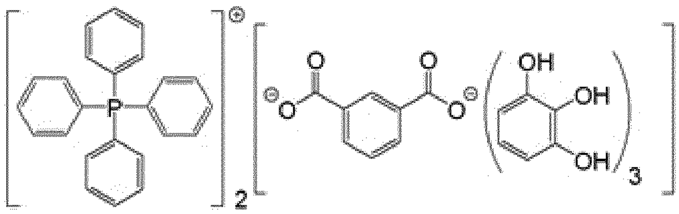

(1f)

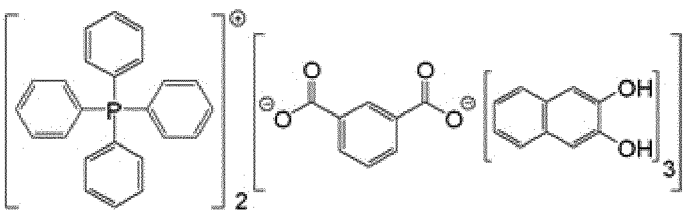

(1g)

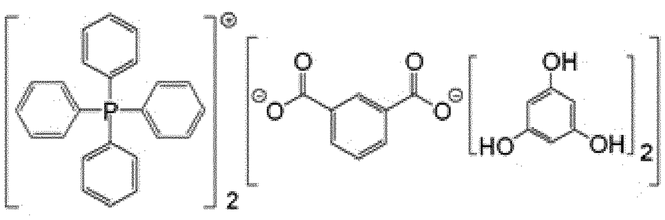

(1h)

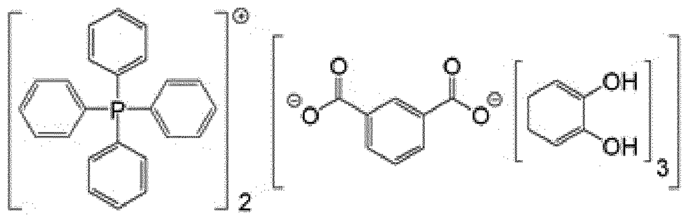

(1i)

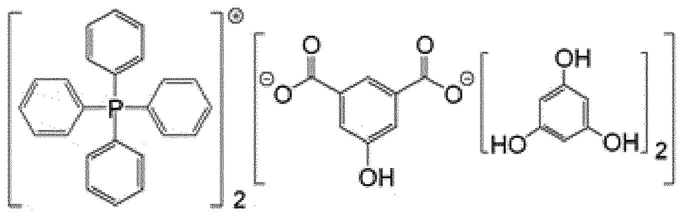

(1j)

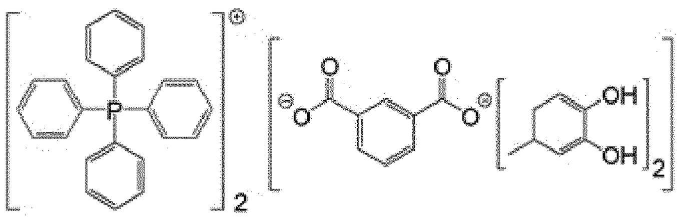

(1k)

5. An epoxy resin composition comprising an epoxy resin, a curing agent, a curing accelerator, and an inorganic filler wherein the curing accelerator comprises a quaternary phosphonium salt according to any of the claims 1 to 4

6. The epoxy resin composition according to claim 5, wherein the epoxy resin, the curing agent, the curing accelerator, and the inorganic filler are present in amounts of 1 % to 20% by weight, 1% to 20% by weight, 0.001% to 2% by weight, and 70% to 95% by weight, respectively.

7. The epoxy resin composition according to claim 5 or 6, wherein the epoxy resin comprises at least one of epoxy resins obtained by epoxidation of condensation products of phenol or alkyl phenols and hydroxybenzaldehyde, phenol novolac type epoxy resins, cresol novolac type epoxy resins, polyfunctional epoxy resins, naphthol novolac type epoxy resins, novolac type epoxy resins of bisphenol A/bisphenol F/bisphenol AD, glycidyl ethers of bisphenol A/bisphenol F/bisphenol AD, bishydroxybiphenyl-based epoxy resins, dicyclopentadiene-based epoxy resins, biphenyl type epoxy resins, polycyclic aromatic-modified epoxy resins, bisphenol A type epoxy resins, ortho-cresol novolac type epoxy resins, phenol aralkyl type epoxy resins, and naphthalene-based epoxy resins.

8. The epoxy resin composition according to any of the claims 5 to 7, wherein the curing agent comprises at least one of phenol aralkyl type phenolic resins, xyloc type phenolic resins, phenol novolac type phenolic resins, cresol novolac type phenolic resins, naphthol type phenolic resins, terpene type phenolic resins, polyfunctional phenolic resins, polycyclic aromatic phenolic resins, dicyclopentadiene-based phenolic resins, terpene-modified phenolic resins, dicyclopentadiene-modified phenolic resins, novolac type phenolic resins synthesized from bisphenol A and resorcinol, polyhydric phenolic compounds, including tris(hydroxyphenyl)methane and dihydroxybiphenyl, acid anhydrides, including maleic anhydride and phthalic anhydride, metaphenylenediamine, diaminodiphenylmethane, and diaminodiphenylsulfone.

9. The epoxy resin composition according to to any of the claims 5 to 8, wherein the epoxy resin and the curing agent are present in such amounts that the ratio of the epoxy equivalent weight of the epoxy resin to the phenolic hydroxyl or amine equivalent weight of the curing agent is from 0.5:1 to 2:1.

10. The epoxy resin composition according to to any of the claims 5 to 8, wherein the inorganic filler comprises at least one of fused silica, crystalline silica, calcium carbonate, magnesium carbonate, alumina, magnesia, clay, talc, calcium silicate, titanium oxide, antimony oxide, and glass fiber.

**11.** A semiconductor device encapsulated with the epoxy resin composition according to any one of claims 5 to 8.

## Patentansprüche

**1.** Quaternäres Phosphoniumsalz, das durch die Formel 1 dargestellt wird:

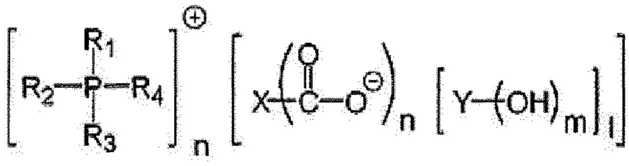

(1)

wobei $R_1$, $R_2$, $R_3$ und $R_4$ jeweils eine unsubstituierte Benzolgruppe sind, X eine unsubstituierte Benzolgruppe ist, Y eine unsubstituierte Benzol-gruppe, eine Naphthalingruppe oder mit einem bis drei unsubstituierten Benzolgruppen substituiertes Si ist, n = 2 ist, m eine ganze Zahl von 1 bis 6 ist, l eine Zahl ist, die größer ist als 0 und kleiner gleich 6, vorausgesetzt, dass, wenn Y Si ist, die Summe von m und der Anzahl der Substituenten maximal 4 beträgt.

**2.** Quaternäres Phosphoniumsalz nach Anspruch 1, wobei m 2 oder 3 beträgt.

**3.** Quaternäres Phosphoniumsalz nach Anspruch 1, wobei l 2, 3 oder 4 beträgt.

**4.** Quaternäres Phosphoniumsalz nach Anspruch 1, wobei das quaternäre Phosphoniumsalz eine der durch die Formeln 1a bis 1k dargestellten Verbindungen ist:

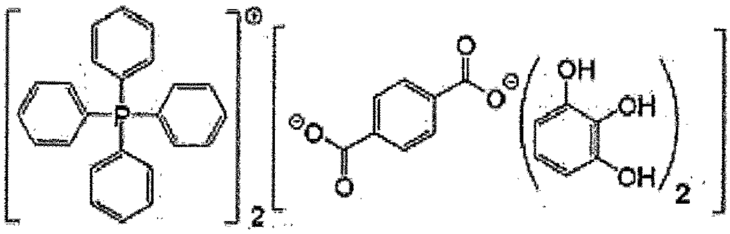

(1a)

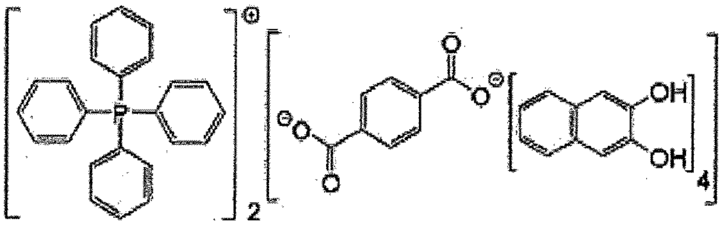

(1b)

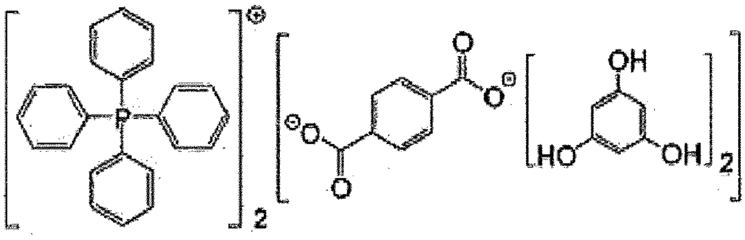

(1c)

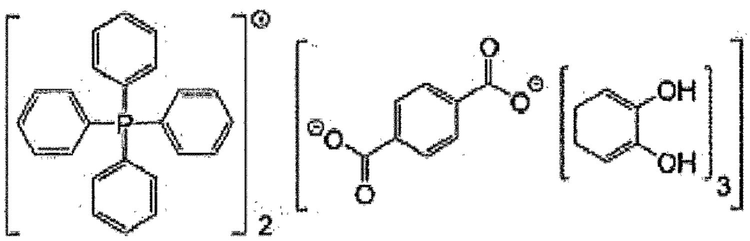

(1d)

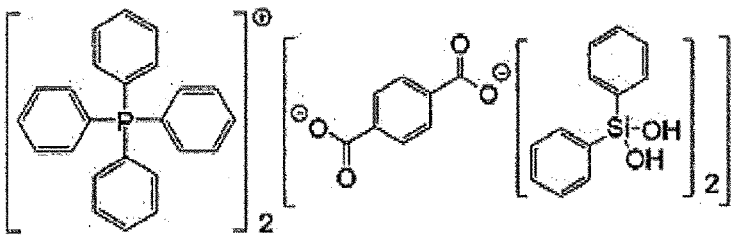

(1e)

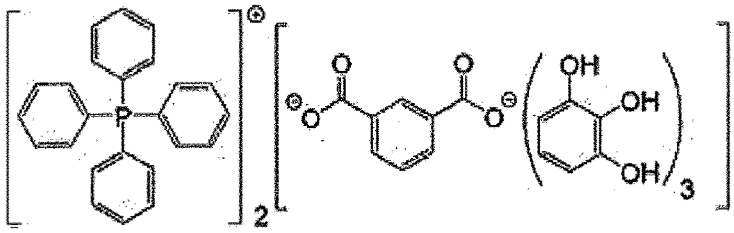

(1f)

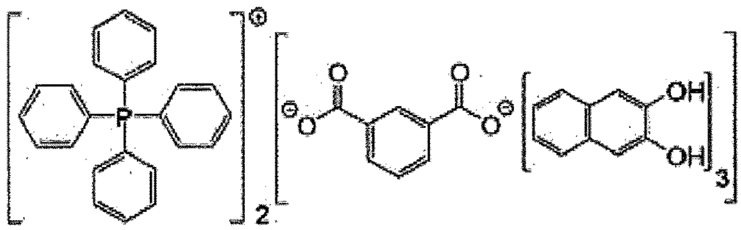

(1g)

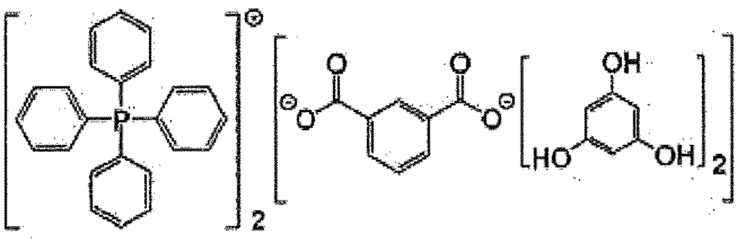

(1h)

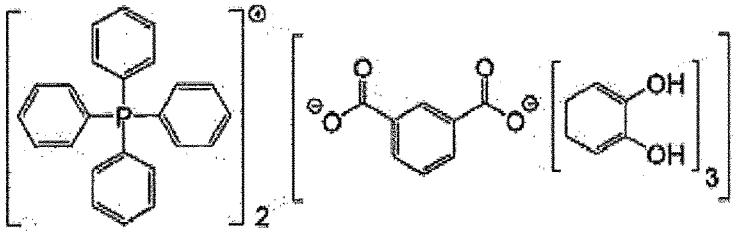

(1i)

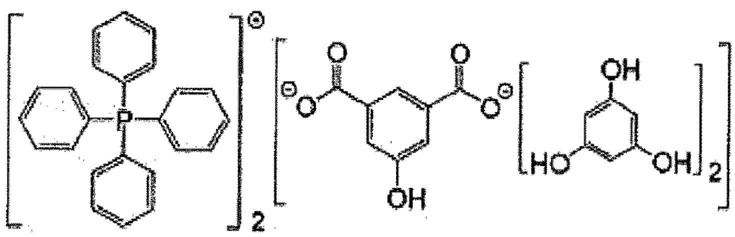

(1j)

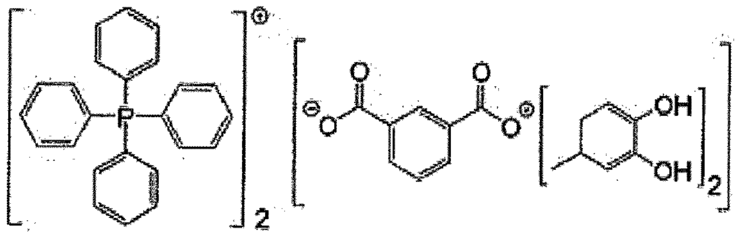

(1k)

5. Epoxidharzverbindung mit einem Epoxidharz, einem Härter, einem Aushärtungsbeschleuniger und einem anorganischen Füllstoff, wobei der Aushärtungsbeschleuniger ein quaternäres Phosphoniumsalz nach einem der Ansprüche 1 bis 4 aufweist.

6. Epoxidharzzusammensetzung nach Anspruch 5, wobei das Epoxidharz, der Härter, der Aushärtungsbeschleuniger und der anorganische Füllstoff in Mengen von 1 bis 20 Gew.-%, 1 bis 20 Gew.-%, 0,001 bis 2 Gew.-% bzw. 70 bis 95 Gew.-% vorhanden sind.

7. Epoxidharzzusammensetzung nach Anspruch 5 oder 6, wobei das Epoxidharz mindestens ein Epoxidharz aufweist, das durch Epoxidierung von Kondensationsprodukten von Phenol oder Alkylphenolen und Hydroxybenzaldehyd, Epoxidharzen des Phenol-Novolak-Typs, Epoxidharzen des Kresol-Novolak-Typs, polyfunktionellen Epoxidharzen, Epoxidharzen des Naphthol-Novolak-Typs, Epoxidharzen des Novolak-Typs von Bisphenol A/Bisphenol F/Bisphenol AD, Glycidylethern von Bisphenol A/Bisphenol F/Bisphenol AD, Epoidharzen auf Bishydroxybiphenylbasis, Epoxidharzen auf Dicyclopentadienbasis, Epoxidharzen des Biphenyltyps, polycyclischen aromatischen modifizierten Epoxidharzen, Epoxidharzen des Bisphenol A-Typs, Epoxidharzen des ortho-Kresol-Novolak-Typs, Epoxidharzen des Phenol-Aralkyl-Typs und Epoxidharzen auf Naphthalinbasis erhalten wird.

8. Epoxidharzzusammensetzung nach einem der Ansprüche 5 bis 7, wobei der Härter mindestens eine Komponente unter Phenolharzen des Phenolaralkyl-typs, Phenolharzen des Xyloctyps, Phenolharzen des Phenol-Novolak-Typs, Phenolharzen des Kresol-Novolak-Typs, Phenolharzen des Naphtholtyps, Phenolharzen des Terpentyps, polyfunktionellen Phenolharzen, polycyclischen aromatischen Phenolharzen, Phenolharzen auf Dicyclopentadienbasis, terpen-modifizierten Phenolharzen, dicyclopentadien-modifizierten Phenolharzen, Phenolharzen des Novolaktyps, synthetisiert von Bisphenol A und Resorcinol, mehrwertigen Phenolverbindungen, wie beispielsweise tris(Hydroxyphenyl)methan und Dihydroxybiphenyl, Säureanhydriden, wie beispielsweise Maleinanhydrid und Phtalanhydrid, Metaphenylendiamin, Diaminodiphenylmethan und Diaminodiphenylsulfon aufweist.

9. Epoxidharzzusammensetzung nach einem der Ansprüche 5 bis 8, wobei das Epoxidharz und der Härter in derartigen Mengen vorhanden sind, dass das Verhältnis zwischen dem Epoxid-Äquivalentgewicht des Epoxidharzes und dem phenolischem Hydroxyl- oder Aminäquivalentgewicht des Härters 0,5:1 bis 2:1 beträgt.

10. Epoxidharzverbindung nach einem der Ansprüche 5 bis 8, wobei der anorganische Füllstoff mindestens eine Komponente unter synthetischen Quarzglas (Fused Silica), kristallinem Silica, Calciumcarbonat, Magnesiumcarbonat, Aluminiumoxid, Magnesia, Ton, Talk, Calciumsilicat, Titanoxid, Antimonoxid und Glasfasern aufweist.

11. Halbleiterelement, das mit einer Epoxidharzzusammensetzung nach einem der Ansprüche 5 bis 8 eingekapselt ist.

## Revendications

**1.** Sel de phosphonium quaternaire représenté par la Formule 1 :

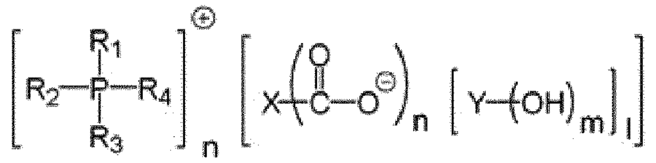

(1)

dans lequel $R_1$, $R_2$, $R_3$ et $R_4$ représentent chacun un groupe benzène non substitué ; X représente un groupe benzène non substitué ; Y représente un groupe benzène non substitué, un groupe naphtalène ou un Si substitué par un à trois groupes benzène non substitués ; n est 2, m est un nombre entier de 1 à 6 ; 1 est un nombre supérieur à 0 à 6, à condition que lorsque Y est Si, la somme de m et du nombre de substituants soit un maximum de 4.

**2.** Sel de phosphonium quaternaire selon la revendication 1, dans lequel m est 2 ou 3.

**3.** Sel de phosphonium quaternaire selon la revendication 1, dans lequel 1 est 2, 3 ou 4.

**4.** Sel de phosphonium quaternaire selon la revendication 1, dans lequel le sel de phosphonium quaternaire est l'un quelconque des composés représentés par les Formules 1a à 1k :

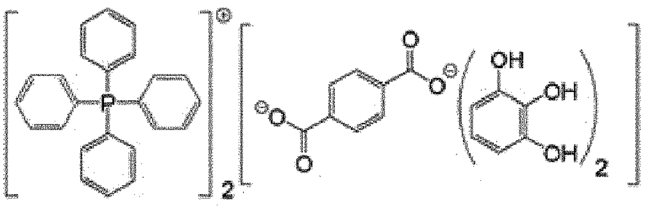

(1a)

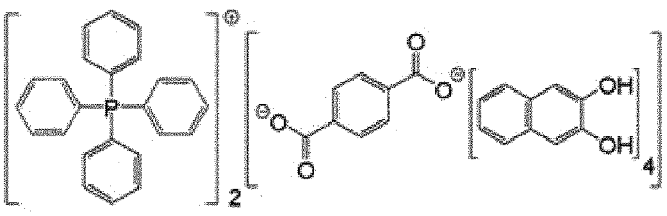

(1b)

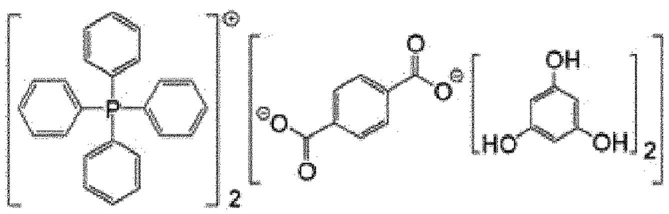

(1c)

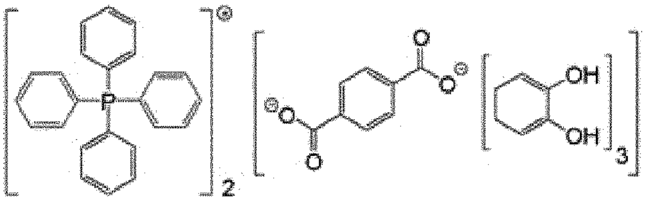

(1d)

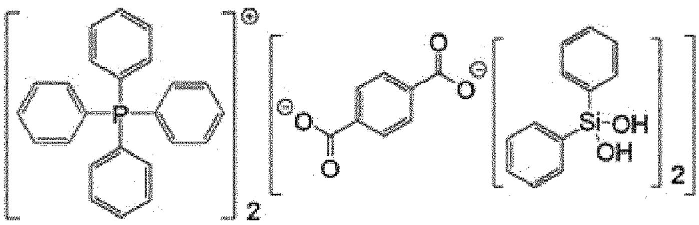

(1e)

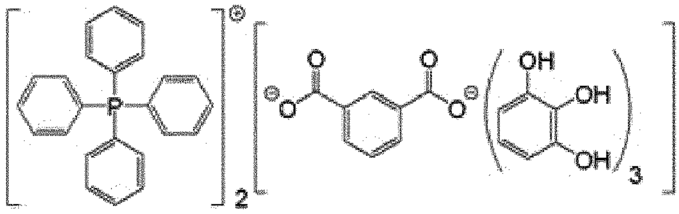

(1f)

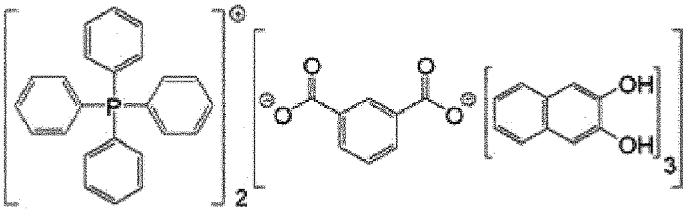

(1g)

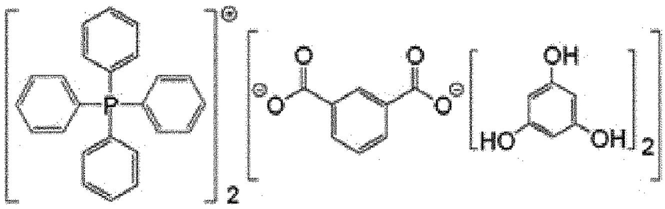

(1h)

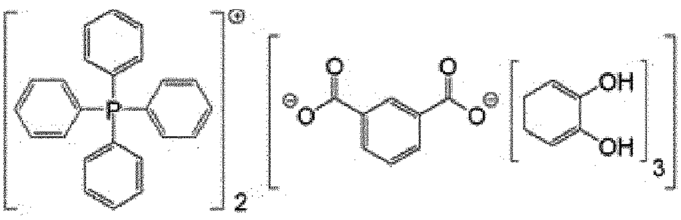

(1i)

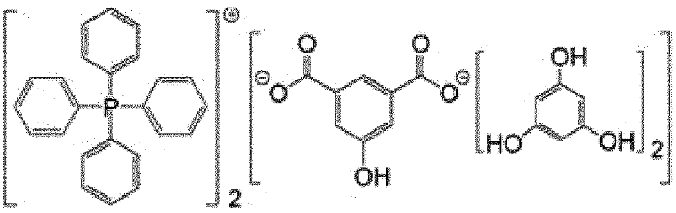

(1j)

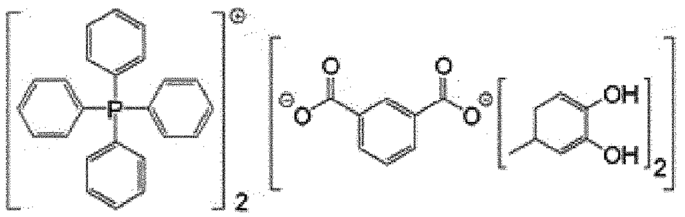

(1k)

5. Composition de résine époxy comprenant une résine époxy, un agent de durcissement, un accélérateur de durcissement et une charge inorganique, dans laquelle l'accélérateur de durcissement comprend un sel de phosphonium quaternaire selon l'une quelconque des revendications 1 à 4

6. Composition de résine époxy selon la revendication 5, dans laquelle la résine époxy, l'agent de durcissement, l'accélérateur de durcissement et la charge inorganique sont présents en quantités de 1% à 20% en poids, 1% à 20% en poids, 0,001 % à 2% en poids et 70% à 95% en poids, respectivement.

7. Composition de résine époxy selon la revendication 5 ou la revendication 6, dans laquelle la résine époxy comprend au moins une parmi des résines époxy obtenues par époxydation de produits de condensation de phénol ou d'alkylphénols et d'hydroxybenzaldéhyde, des résines époxy de type phénol novolaque, des résines époxy de type crésol novolaque, des résines époxy polyfonctionnelles, des résines époxy de type naphtol novolaque, des résines époxy de type novolaque de bisphénol A/bisphénol F/bisphénol AD, des éthers glycidyliques de bisphénol A/bisphénol F/bisphénol AD, des résines époxy à base de bishydroxybiphényle, des résines époxy à base de dicyclopentadiène, des résines époxy à base de biphényle, des résines époxy d'aromatiques polycycliques modifiées, des résines époxy de type bisphénol A, des résines époxy de type ortho-crésol novolaque, des résines époxy de type phénol aralkyle et des résines époxy à base de naphtalène.

8. Composition de résine époxy selon l'une quelconque des revendications 5 à 7, dans laquelle l'agent de durcissement comprend au moins une parmi des résines phénoliques de type phénol aralkyle, des résines phénoliques de type xyloc, des résines phénoliques de type phénol novolaque, des résines phénoliques de type crésol novolaque, des résines phénoliques de type naphtol, des résines phénoliques de type terpène, des résines phénoliques polyfonctionnelles, des résines phénoliques d'aromatiques polycycliques, des résines phénoliques à base de dicyclopentadiène, des résines phénoliques de terpènes modifiés, des résines phénoliques de dicyclopentadiènes modifiés, des résines phénoliques de type novolaque synthétisées à partir de bisphénol A et de résorcinol, des composés phénoliques polyhydriques, incluant le tris(hydroxyphényl)méthane et le dihydroxybiphényle, des anhydrides d'acide, incluant l'anhydride maléique et l'anhydride phtalique, la métaphénylènediamine, le diaminodiphénylméthane et la diaminodiphénylsulfone.

9. Composition de résine époxy selon l'une quelconque des revendications 5 à 8, dans laquelle la résine époxy et l'agent de durcissement sont présents en des quantités telles que le rapport du poids équivalent d'époxy de la résine époxy sur le poids équivalent d'hydroxyle phénolique ou d'amine de l'agent de durcissement est de 0,5:1 à 2:1.

10. Composition de résine époxy selon l'une quelconque des revendications 5 à 8, dans laquelle la charge inorganique comprend au moins un parmi la silice fondue, la silice cristalline, le carbonate de calcium, le carbonate de magnésium, l'alumine, la magnésie, l'argile, le talc, le silicate de calcium, l'oxyde de titane, l'oxyde d'antimoine et la fibre de verre.

11. Dispositif semi-conducteur encapsulé avec la composition de résine époxy selon l'une quelconque des revendications 5 à 8.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 5163335 A
- JP 4153319 A
- JP 2006307131 A
- US 2009234080 A1
- WO 2010078300 A1, Paital
- WO 03082976 A


### Non-patent literature cited in the description


- *Polyhedron,* 2013, 328-338